# EUROPEAN PATENT SPECIFICATION

(11) **EP 3 840 031 B1**
(45) Date of publication and mention of the grant of the patent: **14.02.2024**
(21) Application number: 20215160.1
(22) Date of filing: 17.12.2020
(51) Int. Cl.: H01L 21/74, H01L 23/535

(54) **INTEGRATED DEVICE WITH DEEP CONTACT PLUG AND CORRESPONDING METHOD OF FABRICATION**
INTEGRIERTE VORRICHTUNG MIT TIEFEM KONTAKTSTECKER UND ZUGEHÖRIGE HERSTELLUNGSMETHODE
DISPOSITIF INTÉGRÉ DOTÉ D'UN CONTACT PROFOND ET PROCÉDÉ CORRESPONDANT

(30) Priority: 18.12.2019 IT 201900024532
(43) Date of publication of application: 23.06.2021
(73) Proprietor: STMicroelectronics S.r.l., 20864 Agrate Brianza (MB) (IT)
(72) Inventor: PALEARI, Andrea, 20861 Brugherio (MB) (IT); MARIANI, Simone Dario, 20854 Vedano al Lambro (MB) (IT); BALDI, Irene, 20159 Milano (IT); BRAZZELLI, Daniela, 21052 Busto Arsizio (VA) (IT); MERLINI, Alessandra Piera, 20847 Albiate (MB) (IT)
(74) Representative: Studio Torta S.p.A.

(56) References cited:
- EP-A1- 1 770 784
- EP-A2- 3 193 370
- US-A1- 2011 018 068
- US-A1- 2016 172 314

## Description

### Technical field

The present disclosure relates to the field of integrated devices. More specifically, this disclosure relates to deep plugs.

### Background

The background of the present disclosure is hereinafter introduced with the discussion of techniques relating to its context. However, even when this discussion refers to documents, acts, artifacts and the like, it does not suggest or represent that the discussed techniques are part of the prior art or are common general knowledge in the field relevant to the present disclosure.

Deep trenches are commonly used in integrated devices to reach deep regions of chips wherein they are integrated (for example, their substrates). The deep trenches may be filled with (electrically) insulating material; in this case, the deep trenches are used in Deep Trench Isolation (DTI) techniques to (deeply) insulate different regions of each chip. The deep trenches may also be coated with (electrically) insulating material on their lateral surfaces and then filled with (electrically) conductive material; in this case, the deep trenches are used as deep plugs to (electrically) contact the deep regions of each chip from its front surface. For example, the deep plugs are commonly used to bias a substrate of the chip, to collect parasitic currents from the substrate and so on.

Generally, each deep trench (when used as deep plug) is formed by etching the chip from the front surface (through a corresponding mask) until reaching the desired depth from it. The trench is then coated with the insulating material (opened at its bottom with a dedicated step) and filled with the conductive material. In the end, the insulating material is planarized until reaching the front surface of the chip.

However, the deep plugs require dedicated design rules.

Particularly, the planarization of the conductive material filling the deep trenches is quite difficult to control accurately (on the deep trench and around it). Therefore, this conductive material generally exhibits a bulge or a recess at the front surface. The non-planarity of the conductive material filling the deep trench causes a risk of leaving conductive residues on the front surface of the chip due to the following process steps.

The corresponding electric field generated around the deep plugs at the front surface of the chip may interfere with operation of components integrated on the same chip. This reduces the performance and reliability of the integrated device (for example, with increased defectiveness and risk of breakdown thereof).

Therefore, in order to ensure correct operation of these components, they are generally spaced apart from the deep plugs on the front surface by corresponding guard regions. However, the guard regions (wherein no components are integrated) waste area of the chip; this adversely affects a size of the integrated device.

EP 3193370 discloses an integrated device having the features of the preamble of claim 1.

The aim of the invention is to provide an integrated device having a reduced concentration of electric field at shallow active regions of high-voltage components.

According to the invention, an integrated device and a process for manufacturing an integrated device are provided according to the attached claims.

### Brief description of the drawings

The solution of the present disclosure, as well as further features and the advantages thereof, will be best understood with reference to the following detailed description thereof, given purely by way of a non-restrictive indication, to be read in conjunction with the accompanying drawings (wherein, for the sake of simplicity, corresponding elements are denoted with equal or similar references and their explanation is not repeated, and the name of each entity is generally used to denote both its type and its attributes, like value, content and representation). In this respect, it is expressly intended that the drawings are not necessary drawn to scale (with some details that may be exaggerated and/or simplified) and that, unless otherwise indicated, they are merely used to illustrate the structures and procedures described herein conceptually. Particularly:
FIG.1 shows a schematic representation in cross-section view of an integrated device according to an embodiment of the present disclosure,
FIG.2A-FIG.2J show the main steps of a manufacturing process of the integrated device according to an embodiment of the present disclosure,
FIG.3 shows a schematic representation in cross-section view of a further integrated device according to an embodiment of the present disclosure,
FIG.4A-FIG.4B show the main steps of a manufacturing process of the further integrated device according to an embodiment of the present disclosure, and
FIG.5 shown a schematic block diagram of a system incorporating the integrated device according to an embodiment of the present disclosure.

### Detailed description

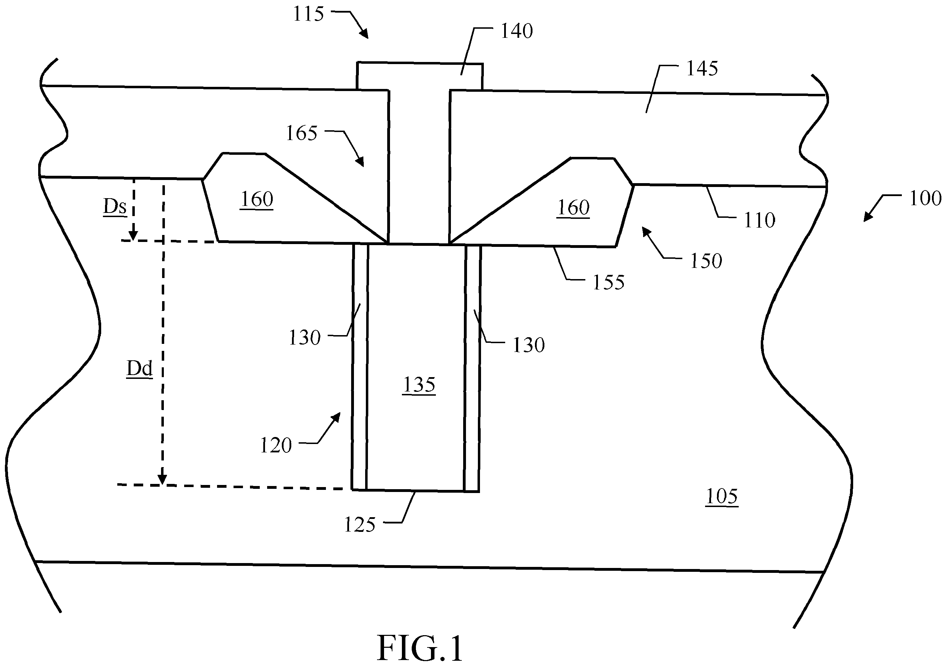

With reference in particular to FIG.1, a schematic representation is shown in cross-section view of an integrated device 100 according to an embodiment of the present disclosure.

The integrated device 100 is integrated on a semiconductor body, for example, a chip (or die) 105 of semiconductor material (such as silicon). The chip 105 has a (main) front surface 110 (used to contact components integrated on the chip 105, not shown in the figure).

The integrated device 100 comprises a deep plug 115 (or more), which is used to (electrically) contact the chip 105 deeply (for example, to bias a substrate of the chip 105, not indicated in the figure, to collect parasitic currents from the substrate and so on). The deep plug 115 comprises a deep trench 120. The deep trench 120 extends (deeply) in the chip 105 to a (deep) depth Dd from the front surface 110. The deep trench 120 has a deep surface 125 at the depth Dd (buried within the chip 105) and a lateral surface coated with an insulating coating 130 of (electrically) insulating material (such as silicon oxide); the (coated) deep trench 120 is then filled with a conductive filler 135 of (electrically) conductive material (such as doped polysilicon). A trench contact 140 of (electrically) conductive material (such as metal) is provided for contacting the conductive filler 135. For this purpose, the trench contact 140 crosses a corresponding window being opened across a protective layer 145 of (electrically) insulating material (for example, silicon dioxide) covering the whole chip 105 (on the front surface 110).

The integrated device 100 further comprises a shallow trench 150 (or more). The shallow trench 150 extends in the chip 105 from the front surface 110 to a (shallow) depth Ds; the depth Ds is (strictly) lower than the depth Dd, for example, with the depth Dd equal to 5-100 times the depth Ds. The shallow trench 150 has a shallow surface 155 at the depth Ds (buried less deeply within the chip 105 than the deep surface 125). The shallow trench 150 is filled with an insulating filler 160 of (electrically) insulating material (such as silicon oxide). The shallow trenches are commonly used in Shallow Trench Isolation (STI) techniques to (shallowly) insulate different regions of each chip (and particularly to prevent current leakage between adjacent components in the chip).

The deep trench 120 extends in the chip 105 from the shallow surface 155 (of the shallow trench 150) to the depth Dd. Moreover, the trench contact 140 contacts the conductive filler 135 through the shallow trench 150 at its shallow surface 155. For this purpose, the trench contact 140 crosses a (trench) window 165 being opened across the (filled) shallow trench 150.

The above-described solution does not require dedicated design rules for the deep plug 115.

Indeed, in this case there is no risk of leaving conductive residues on the front surface 110. This avoids (or at least substantially reduces) any interference with operation of components integrated on the chip 105. Therefore, no guard region (or at least a very narrow one) is required around the deep plug 115. All of the above involves a significant saving of area of the chip 105, with a beneficial effect on a size of the integrated device 100 (at the same time, without any degradation of performance and reliability thereof).

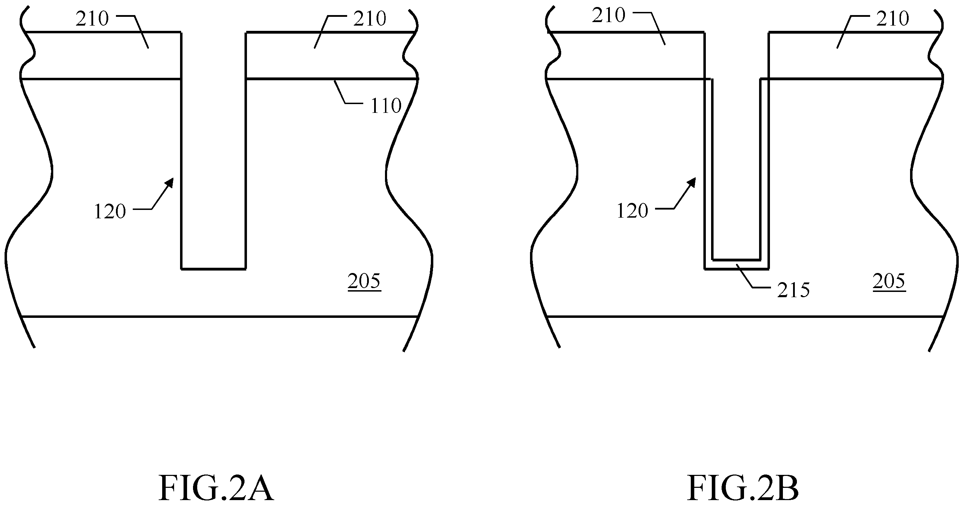

With reference now to FIG.2A-FIG.2J, the main steps are shown of a manufacturing process of the integrated device according to an embodiment of the present disclosure.

Starting from FIG.2A, the manufacturing process is performed at the level of a wafer 205 of semiconductor material, wherein the same structure is integrated simultaneously in a large number of identical areas thereof (only one referred to in the following for the sake of simplicity). A mask 210 for the deep trench is formed (for example, with photo-lithographic techniques) on a front surface of the wafer 205 which will define the front surface of the corresponding chip and then is denoted with the same reference 110. The wafer 205 is etched through the mask 210 (for example, with dry etching techniques) to form the deep trench 120.

Moving to FIG.2B, the deep trench 120 is coated with an insulating layer 215 (for example, silicon oxide grown with thermal oxidation techniques on any surfaces of the wafer 205 being exposed through the mask 210).

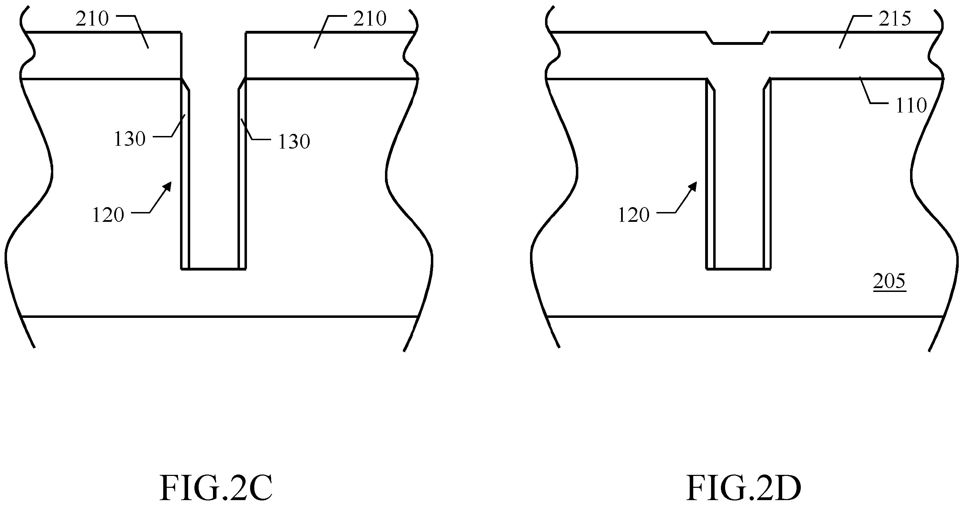

Moving to FIG.2C, the insulating layer is selectively etched through the mask 210 (for example, with dry etching techniques); the process removes the insulating layer at the bottom of the deep trench 120 (with a negligible removal thereof at the top of its lateral surface), so as to leave the insulating coating 130.

Moving to FIG.2D, the mask is stripped. A conductive layer 215 (for example, of doped polysilicon) is deposited onto the wafer 205 so as to fill the (coated) deep trench 120 and to cover the front surface 110.

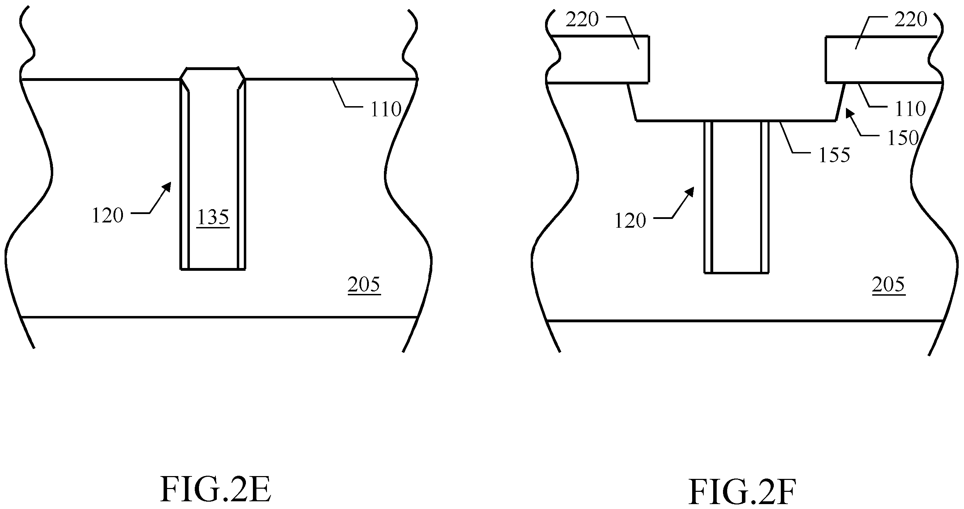

Moving to FIG.2E, the wafer 205 is planarized (for example, with CMP techniques) to remove an excess of the conductive layer from the front surface 110, until leaving the deep trench 120 filled with the (remaining) conductive layer that defines the conductive filler 135. The planarization of the deep trench 120 might be irregular, as represented in the figure with an (exaggerated) bulge of the conductive filler 135.

Moving to FIG.2F, a further mask 220 for the shallow trench is formed (for example, with photolithographic techniques) onto the wafer 205; the mask 220 leaves exposed the (filled) deep trench 120 and a portion of the front surface 110 around it (centered on the deep trench 120). The wafer 205 is etched through the mask 220 (for example, with dry etching techniques) to form the shallow trench 150. This operation removes a corresponding (upper) portion of the deep trench 120 extending from the front surface 110 to the shallow surface 155, so that any irregularities due to its planarization automatically disappear. As a result, the remaining (lower) deep trench 120 extends in the wafer 205 from the shallow surface 155.

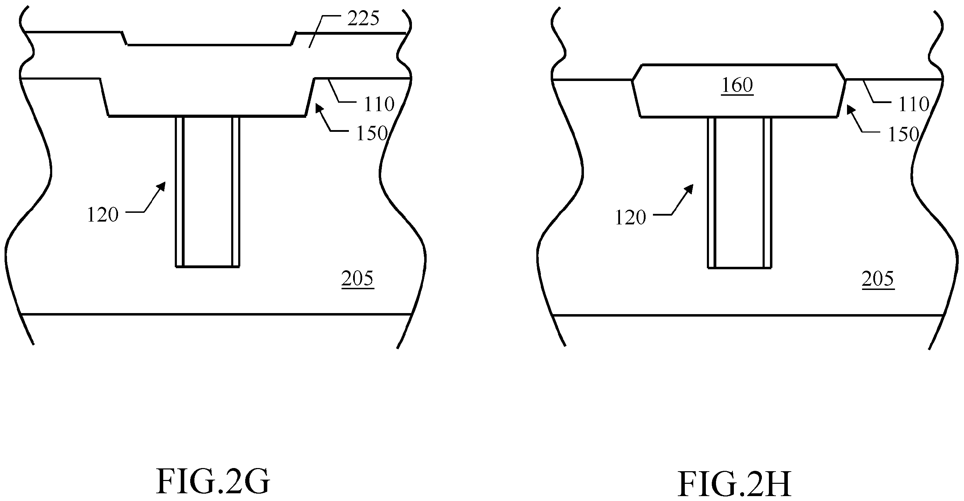

Moving to FIG.2G, the mask is stripped. An insulating layer 225 (for example, of silicon oxide) is deposited (possibly after a thermal oxidation step) onto the wafer 205 so as to fill the shallow trench 150 (thereby covering the deep trench 120 as well) and to cover the front surface 110 (possibly covered by a layer of silicon nitride, not shown in the figure).

Moving to FIG.2H, the wafer 205 is planarized (for example, with CMP techniques) to remove an excess of the insulating layer from the front surface 110, until leaving the shallow trench 150 filled with the (remaining) insulating layer that defines the insulating filler 160. In this case as well, the planarization of the shallow trench 150 might be irregular, as represented in the figure with an (exaggerated) bulge of the insulating filler 160. As a result, the (filled) deep trench 120 is coaxial with the (filled) shallow trench 150 (perpendicularly to the front surface 110). The shallow trench 150 has a transversal cross-section (in any plan parallel to the front surface 110) which is larger than the one of the deep trench 120 (for example, 2-4 times), so that in plant view the shallow trench 150 surrounds the deep trench 120 completely.

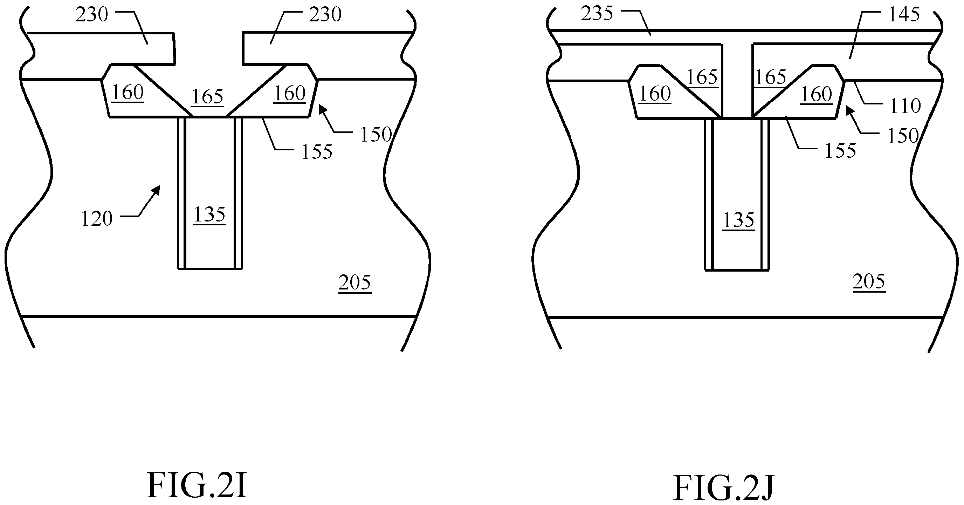

Moving to FIG.2I, a further mask 230 is formed (for example, with photolithographic techniques) onto the wafer 205; the mask 230 leaves exposed a central portion of the shallow trench 150 for contacting the deep trench 120. The insulating filler 160 is etched through the mask 230 (for example, with wet etching techniques) until reaching the deep trench 120, thereby forming the corresponding trench window 165. The trench window 165 is coaxial with the deep trench 120 (perpendicularly to the front surface 110). The trench window 165 has a transversal cross-section (in the plan of the shallow surface 155) which is smaller than the one of the deep trench 120, so that the trench window 165 only exposes a central portion of the conductive filler 135 of the deep trench 120 at the shallow surface 155 (for example, 70-80% thereof).

Moving to FIG.2J, the protective layer 145 is deposited on the wafer 205 so as to fill the trench window 165 and to cover the (remaining) insulating filler 160 and the front surface 110. The protective layer 145 is removed selectively (for example, with dry etching techniques through a corresponding mask, not shown in the figure) to form a window (coaxial with the deep trench 120 perpendicularly to the front surface 110), which exposes the central portion of the conductive filler 135 (begin exposed at the shallow surface 155 by the trench window 165). A metal layer 235 (for example, of copper) is deposited on the wafer 205 so as to fill the window exposing the conductive filler 135 and to cover the protective layer 145. In this way, the whole conductive filler 135 being exposed is contacted, with the rest thereof that is protected by the shallow trench 150 (thereby further increasing performance and reliability). The metal layer 235 is selectively removed (for example, with dry etching techniques through a corresponding mask, not shown in the figure) to form the trench contact, thereby obtaining the desired structure (as shown in FIG.1). At this point (after possible other metal levels required by the integrated device), the areas of the wafer 205 (wherein the same structures are formed) are separated into corresponding chips through a cutting operation.

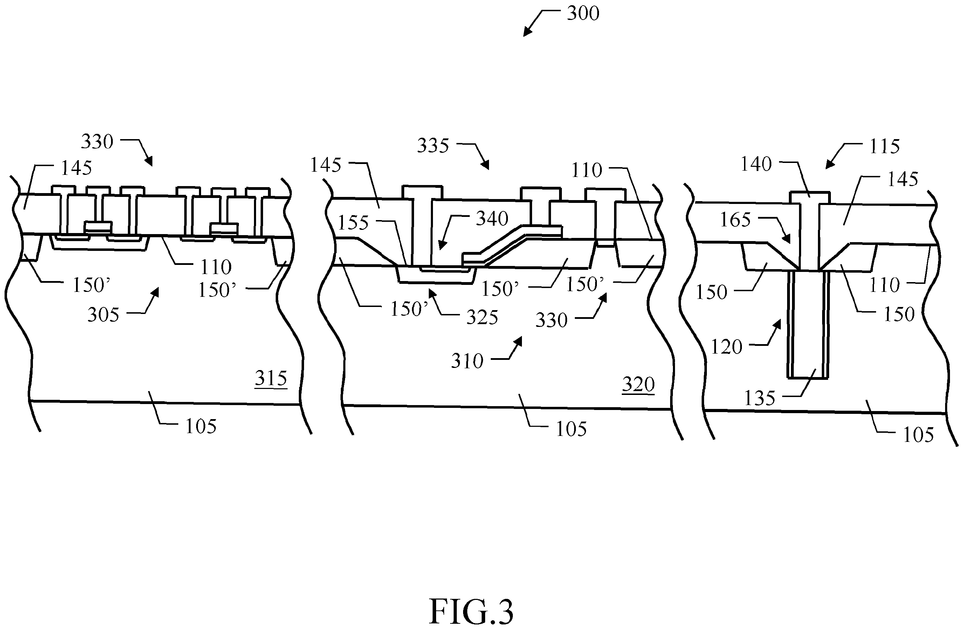

With reference now to FIG.3, a schematic representation is shown in cross-section view of a further integrated device 300 according to an embodiment of the present disclosure (wherein elements in common with the preceding figures are denoted with the same references).

As above, the integrated device 300 is integrated on a chip 105 having a front surface 110. The integrated device 300 comprises a deep plug 115 (or more), with a deep trench 120 extending below a shallow trench 150. In this case, the integrated device 300 is of mixed type, comprising both low-voltage (or signal) components 305 (enlarged in the figure) and high-voltage (or power) components 310. The low-power components 305 are designed to work at relatively low voltages, whereas the high-voltage components 310 are designed to work at relatively high voltages; for example, the high voltages are 50-500 times the low voltages (such as 2-10V and 100-2,000V, respectively). For example, the integrated device 300 is of Bipolar-CMOS-DMOS (BCD) type, with a CMOS of the low-voltage components 305 and a DMOS of the high-voltage components 310 shown in the figure. The chip 105 has a low-voltage area 315 for the low-voltage components 305 and a high-voltage area 320 for the high-voltage components 310. One or more (further) shallow trenches, differentiated with the reference 150', extend in the chip 105 from the front surface 110. The shallow trenches 150' insulate the components integrated on the chip 105, comprising the low-voltage area 315 from the high-voltage area 320.

As usual, the low-voltage components 305 have their active regions that extend in the low-voltage area 315 from the front surface 110; for example, the active regions of the low-voltage components 305 comprise a body region, a source region and a drain region for a first MOS of the CMOS (to the left in the figure) and a source region and a drain region of a second (complementary) MOS of the CMOS (to the right in the figure). The low-voltage components 305 are then completed by a gate insulating layer and a gate region stacked on the front surface 110 over a channel region between each pair of source/drain regions.

The high-voltage components 310, instead, have at least part of their active regions, denoted as shallow active regions 325, which extend in the high-voltage area 320 from the shallow surface 155 of a selected (further) shallow trench 150' (or more), as described in US-A-2015/0130750. In this way, the shallow active regions 325 are formed in a so-called Shallow Trench Active (STA) area under the shallow trench 150'. The high-voltage components 310 may also have other active regions, denoted as front active regions 330, which extend in the high-voltage area 320 from the front surface 110 as usual. For example, the shallow active regions 325 comprise a body region and a source region and the front active regions 330 comprise a drain contact region of the DMOS. The high-voltage components 310 are then completed by a gate insulating layer and a gate region stacked on the shallow surface 155 over a channel region between the source/drain regions and a drain junction between the body/drain regions, which gate insulating layer/region extend up to the front surface 110 on an interface surface of the shallow trench 150' between the shallow surface 155 and the front surface 110. As above, a protective layer 145 covers the whole chip 105, with a trench contact 140 for the deep trench 120 (*i.e.,* its conductive filler 135) crossing the protective layer 145 through a trench window 165 in the corresponding shallow trench 150. Moreover, similar components contacts 330 and 335 (crossing the protective layer 145 as well) are provided for the low-voltage components 305 and the high-voltage components 310, respectively; particularly, at least part of the shallow active regions 325 are contacted by one or more of the component contacts 335 crossing the protective layer 145 through a (component) window 340 in the corresponding shallow trench 150'.

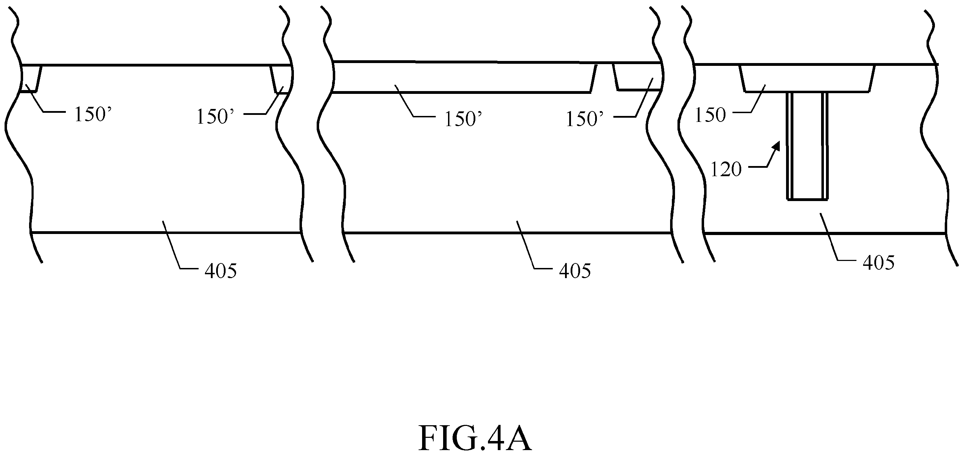

With reference now to FIG.4A-FIG.4B, the main steps are shown of a manufacturing process of the further integrated device according to an embodiment of the present disclosure.

Starting from FIG.4A, as above the manufacturing process is performed at the level of a wafer 405 of semiconductor material, wherein the same structure is integrated simultaneously in a large number of identical areas thereof (only one referred to in the following for the sake of simplicity). The deep trench 120 and the corresponding shallow trench 150 are formed as described above; at the same time, the shallow trenches 150' are formed together with the shallow trench 150.

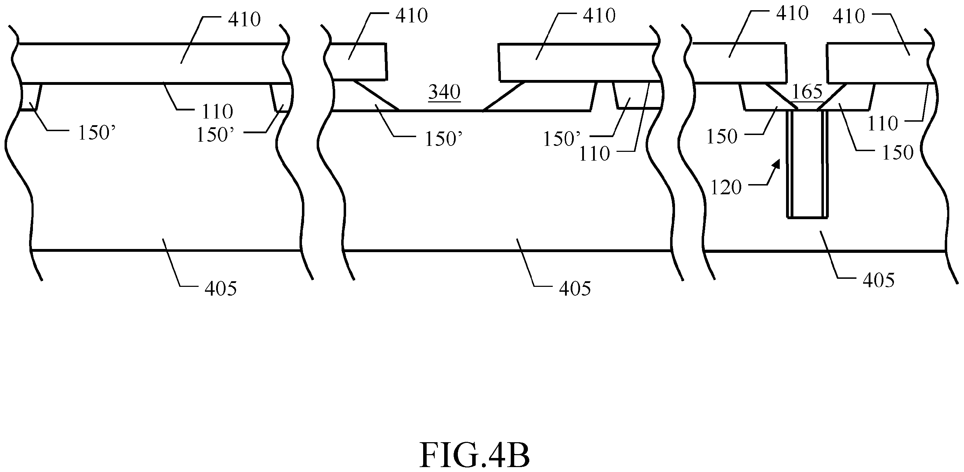

Moving to FIG.4B, a mask 410 is formed (for example, with photo-lithographic techniques) onto the wafer 405; the mask 410 leaves exposed a portion of the shallow trench 150 for contacting the deep trench 120 and a portion of the shallow trench 150' for the next formation of the shallow active regions (of the high-voltage components). The insulating filler of the shallow trenches 150,150' is etched through the mask 410 to form the trench window 165 (for the deep trench 120) across the shallow trench 150 and the component window 340 (for the shallow active regions) across the shallow trench 150'. In this way, the additional operation required for forming the deep plug (*i.e.,* opening the trench window 165 across the shallow trench 150) is performed together with the operation already used to form the integrated device (*i.e.,* opening the component window 340 for the shallow active regions) without the need of any additional process step (and then with no added costs). Particularly, the etching is isotropic (for example, performed with wet etching techniques), so that it also acts in a direction parallel to the front surface 110 and then under the mask 410 (in addition to in a direction perpendicular to the front surface 110). As a result, an angle formed by the lateral surface of the trench/component windows 165,340 with the front surface 110 is lower than an angle formed by a lateral surface of the shallow trenches 150,150' (for example, 20-70° and 80-90°, respectively); this reduces a concentration of electric field at the shallow active regions of the high-voltage components (where it is more critical), so as to improve their performance and reliability.

The process then continues as described in US-A-2015/0130750, with the same process steps used to complete the low-voltage components and the high-voltage components that are also used to contact the deep trench 120. Briefly, a layer of gate oxide is thermally grown on the wafer 405, the body regions are implanted and diffused, a layer of doped polysilicon is deposited on the layer of gate oxide, the two layers are selectively etched to form the gate insulating layers and the gate regions, the drain regions, source regions and drain contact region are implanted and diffused, a layer of protective material is deposited onto the wafer and selectively etched to open corresponding windows for the component contacts (and for the trench contact), a layer of metal is deposited onto the wafer and selectively etched to form the component contacts (and the trench contact).

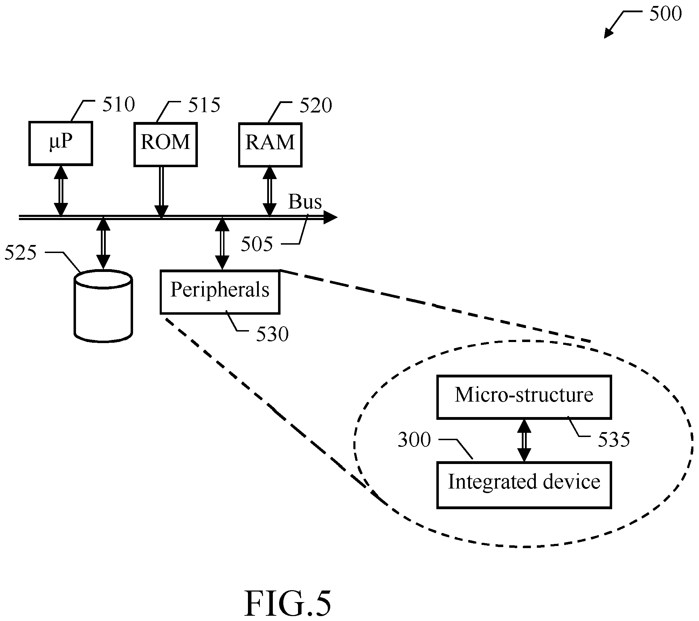

With reference now to FIG.5, a schematic block diagram is shown of a system 500 incorporating the integrated device according to an embodiment of the present disclosure.

The system 500 (for example, a control unit for automotive applications) comprises several components that are connected among them through a bus structure 505 (with one or more levels). Particularly, one or more microprocessors (µP) 510 provide processing and orchestration functionalities of the system 500; a non-volatile memory (ROM) 515 stores basic code for a bootstrap of the system 500 and a volatile memory (RAM) 520 is used as a working memory by the microprocessors 510. The system has a mass-memory 525 for storing programs and data (for example, a flash E²PROM). Moreover, the system 500 comprises a number of controllers of peripheral, or Input/Output (I/O), units, 530 (such as a Wi-Fi WNIC, a Bluetooth transceiver, a GPS receiver, an accelerometer, a gyroscope and so on). Particularly, one or more of the peripherals 530 each comprises a micro (electro-mechanical) structure 535 (for example, one or more sensors/actuators) and the integrated device 300 for controlling the microstructure 535.

### Modifications

Each numerical value should be read as modified according to applicable tolerances; particularly, unless otherwise indicated, the terms "substantially", "about", "approximately" and the like should be understood as within 10%, preferably 5% and still more preferably 1%. Moreover, each range of numerical values should be intended as expressly specifying any possible number along the continuum within the range (comprising its end points). Ordinal or other qualifiers are merely used as labels to distinguish elements with the same name but do not by themselves connote any priority, precedence or order. The terms include, comprise, have, contain, involve and the like should be intended with an open, non-exhaustive meaning (*i*.*e*., not limited to the recited items), the terms based on, dependent on, according to, function of and the like should be intended as a non-exclusive relationship (*i.e.,* with possible further variables involved), the term a/an should be intended as one or more items (unless expressly indicated otherwise), and the term means for (or any means-plus-function formulation) should be intended as any structure adapted or configured for carrying out the relevant function.

## Claims

1. An integrated device (100;300) being integrated on a semiconductor body (105) having a main surface (110), wherein the integrated device (100,300) comprises a deep plug (115) comprising:
a deep trench (120) extending in the semiconductor body (105) to a deep depth (Dd) from the main surface (110), the deep trench (120) having a lateral surface being coated with an insulating coating (130) of electrically insulating material and the coated deep trench (120) being filled with a conductive filler (135) of electrically conductive material,
a trench contact (140) of electrical conductive material contacting the conductive filler (135), and
a shallow trench (150) extending in the semiconductor body (105) from the main surface (110), the shallow trench (150) having a shallow surface (155) at a shallow depth (Ds) from the main surface (110) lower than the deep depth (Dd) and being filled with an insulating filler (160) of electrically insulating material, wherein the deep trench (120) extends from the shallow surface (155) to the deep depth (Dd) and the trench contact (140) contacts the conductive filler (135) through the shallow trench (150) at the shallow surface (155), wherein:
the shallow trench (150) is coaxial with the deep trench (120),
a transversal cross-section of the shallow trench (150) is larger than a transversal cross-section of the deep trench (120), and
a trench window (165) across the insulating filler (160)exposes a central portion of the conductive filler (135), the trench contact (140) contacting the central portion of the conductive filler (135) through the trench window (165),
**characterized in that** a sidewall of the trench window (165) forms an angle of 20-70° with the main surface (110).

2. The integrated device (300) according to claim 1, wherein the integrated device (300) comprises one or more further shallow trenches (150') insulating a low-voltage area (315) and a high-voltage area (320) of the semiconductor body (105), the low-voltage area (315) comprising one or more low-voltage components (305) of the integrated device (300) designed to work at a low-voltage and the high-voltage area (320) comprising one or more high-voltage components (310) of the integrated device (300) designed to work at a high-voltage higher than the low-voltage, wherein the low-voltage components (305) comprises one or more active regions extending in the low-voltage area (315) from the main surface (110) and the high-voltage components (310) comprises one or more active regions (325) extending in the high-voltage area (320) from the shallow surface (155) of at least a selected one of the further shallow trenches (150').

3. The integrated device (300) according to claim 2, wherein a component window (340) across the selected further shallow trench (150') exposes at least part of the shallow surface (155) thereof, one or more component contacts (335) contacting at least part of the active regions (325) of the high-voltage components (310) through the component window (340).

4. The integrated device (300) according to claim 3 wherein a sidewall of the component window (340) forms an angle of 20-70° with the main surface (110).

5. A system (500) comprising at least one integrated device (300) according to any claim from 1 to 4.

6. A process for manufacturing an integrated device (100;300) integrated on a semiconductor body (105) having a main surface (110), wherein the process comprises forming a deep plug (115) comprising:
forming a deep trench (120) extending in the semiconductor body (105) to a deep depth (Dd) from the main surface (110),
coating a lateral surface of the deep trench (120) with an insulating coating of electrically insulating material (130),
filling the coated deep trench (120) with a conductive filler (135) of electrically conductive material,
forming a shallow trench (150) extending in the semiconductor body (105) from the main surface (110) to a shallow surface (155) at a shallow depth (Ds) lower than the deep depth (Dd) to have the deep trench (120) extending from the shallow surface (155) to the deep depth (Dd),
filling the shallow trench (150) with an insulating filler (160) of electrically insulating material, and
forming a trench contact (140) contacting the conductive filler (135) at the shallow surface (155) through the shallow trench (150),
wherein forming the shallow trench (150) is performed after forming the deep trench (120), coating the lateral surface of the deep trench (120) and filling the coated deep trench (120),
and wherein forming the deep plug (115) further comprises:
opening a trench window (165) across the shallow trench (150) exposing at least part of the conductive filler (135), and
forming the trench contact (140) across the trench window (165),
**characterized in that** a sidewall of the trench window (165) forms an angle of 20-70° with the main surface (110).

7. The process according to claim 6, wherein the process comprises:
forming one or more further shallow trenches (150') insulating a low-voltage area (315) and a high-voltage area (320) of the semiconductor body (105), and
forming one or more low-voltage components (305) of the integrated device (300) designed to work at a low-voltage in the low-voltage area (315), the low-voltage components (305) comprising one or more active regions extending in the low-voltage area (315) from the main surface (110), and
forming one or more high-voltage components (310) of the integrated device (300) designed to work at a high-voltage higher than the low-voltage in the high-voltage area (320), the high-voltage components (310) comprising one or more active regions (325) extending in the high-voltage area (320) from the shallow surface (155) of at least a selected one of the further shallow trenches (150).

8. The process according to claim 7, wherein the process comprises:
opening a component window (340) across the selected further shallow trench (150') exposing at least part of the shallow surface (155) thereof together with the trench window (165), and
forming the active regions (325) of the high-voltage components (310) across the component window (335).

9. The process according to claim 8, wherein the process comprises:
opening the component window (340) and the trench window (165) by isotropic etching.

## Patentansprüche

1. Integrierte Vorrichtung (100 ; 300), die auf einem Halbleiterkörper (105) integriert ist, der eine Hauptfläche (110) aufweist, wobei die integrierte Vorrichtung (100, 300) einen tiefen Stecker (115) umfasst, umfassend:
einen tiefen Graben (120), der sich im Halbleiterkörper (105) von der Hauptfläche (110) zu einer tiefen Tiefe (Dd) erstreckt, wobei der tiefe Graben (120) eine seitliche Fläche aufweist, die mit einer isolierenden Beschichtung (130) aus elektrisch isolierendem Material beschichtet ist, und wobei der beschichtete tiefe Graben (120) mit einem leitenden Füllstoff (135) aus elektrisch leitendem Material gefüllt ist,
einen Grabenkontakt (140) aus elektrisch leitendem Material, der den leitenden Füllstoff (135) kontaktiert, und
einen flachen Graben (150), der sich im Halbleiterkörper (105) von der Hauptfläche (110) erstreckt, wobei der flache Graben (150) eine flache Fläche (155) auf einer flachen Tiefe (Ds) von der Hauptfläche (110) aufweist, die niedriger ist als die tiefe Tiefe (Dd), und mit einem isolierenden Füllstoff (160) aus elektrisch isolierendem Material gefüllt ist, wobei sich der tiefe Graben (120) von der flachen Fläche (155) zur tiefen Tiefe (Dd) erstreckt und der Grabenkontakt (140) den leitenden Füllstoff (135) durch den flachen Graben (150) an der flachen Fläche (155) kontaktiert, wobei:
der flache Graben (150) mit dem tiefen Graben (120) koaxial ist,
ein Querschnitt des flachen Grabens (150) größer ist als ein Querschnitt des tiefen Grabens (120), und
ein Grabenfenster (165) über dem isolierenden Füllstoff (160) einen zentralen Abschnitt des leitenden Füllstoffs (135) freilegt, wobei der Grabenkontakt (140) den zentralen Abschnitt des leitenden Füllstoffs (135) durch das Grabenfenster (165) kontaktiert,
**dadurch gekennzeichnet, dass** eine Seitenwand des Grabenfensters (165) einen Winkel von 20-70° zur Hauptfläche (110) bildet.

2. Integrierte Vorrichtung (300) nach Anspruch 1, wobei die integrierte Vorrichtung (300) einen oder mehrere weitere flache Gräben (150') umfasst, die einen Niederspannungsbereich (315) und einen Hochspannungsbereich (320) des Halbleiterkörpers (105) isolieren, wobei der Niederspannungsbereich (315) eine oder mehrere Niederspannungskomponenten (305) der integrierten Vorrichtung (300) umfasst, die darauf ausgelegt sind, bei einer niedrigen Spannung zu arbeiten, und wobei der Hochspannungsbereich (320) eine oder mehrere Hochspannungskomponenten (310) der integrierten Vorrichtung (300) umfasst, die darauf ausgelegt sind, bei einer hohen Spannung zu arbeiten, die höher ist als die niedrige Spannung, wobei die Niederspannungskomponenten (305) eine oder mehrere aktive Regionen umfassen, die sich im Niederspannungsbereich (315) von der Hauptfläche (110) erstrecken, und die Hochspannungskomponenten (310) eine oder mehrere aktive Regionen (325) umfassen, die sich im Hochspannungsbereich (320) von der flachen Fläche (155) mindestens eines ausgewählten der weiteren flachen Gräben (150') erstrecken.

3. Integrierte Vorrichtung (300) nach Anspruch 2, wobei ein Komponentenfenster (340) über dem ausgewählten weiteren flachen Graben (150') mindestens einen Teil der flachen Fläche (155) desselben freilegt, wobei ein oder mehrere Komponentenkontakte (335) mindestens einen Teil der aktiven Regionen (325) der Hochspannungskomponenten (310) durch das Komponentenfenster (340) kontaktieren.

4. Integrierte Vorrichtung (300) nach Anspruch 3, wobei eine Seitenwand des Komponentenfensters (340) einen Winkel von 20-70° zur Hauptfläche (110) bildet.

5. System (500), das mindestens eine integrierte Vorrichtung (300) nach einem von Anspruch 1 bis 4 umfasst.

6. Prozess zum Herstellen einer integrierten Vorrichtung (100; 300), die auf einem Halbleiterkörper (105) integriert ist, der eine Hauptfläche (110) aufweist, wobei der Prozess das Bilden eines tiefen Steckers (115) umfasst, umfassend:
Bilden eines tiefen Grabens (120), der sich im Halbleiterkörper (105) von der Hauptfläche (110) zu einer tiefen Tiefe (Dd) erstreckt,
Beschichten einer seitlichen Fläche des tiefen Grabens (120) mit einer isolierenden Beschichtung aus elektrisch isolierendem Material (130),
Füllen des beschichteten tiefen Grabens (120) mit einem leitenden Füllstoff (135) aus elektrisch leitendem Material,
Bilden eines flachen Grabens (150), der sich im Halbleiterkörper (105) von der Hauptfläche (110) zu einer flachen Fläche (155) auf einer flachen Tiefe (Ds) erstreckt, die niedriger ist als die tiefe Tiefe (Dd),
sodass sich der tiefe Graben (120) von der flachen Fläche (155) zur tiefen Tiefe (Dd) erstreckt,
Füllen des flachen Grabens (150) mit einem isolierenden Füllstoff (160) aus elektrisch isolierendem Material, und
Bilden eines Grabenkontakts (140), der den leitenden Füllstoff (135) an der flachen Fläche (155) durch den flachen Graben (150) kontaktiert,
wobei das Bilden des flachen Grabens (150) nach dem Bilden des tiefen Grabens (120), Beschichten der seitlichen Fläche des tiefen Grabens (120) und Füllen des beschichteten tiefen Grabens (120) durchgeführt wird,
und wobei das Bilden des tiefen Steckers (115) weiter umfasst:
Öffnen eines Grabenfensters (165) über dem flachen Graben (150), das mindestens einen Teil des leitenden Füllstoffs (135) freilegt, und
Bilden des Grabenkontakts (140) über dem Grabenfenster (165),
**dadurch gekennzeichnet, dass** eine Seitenwand des Grabenfensters (165) einen Winkel von 20-70° zur Hauptfläche (110) bildet.

7. Prozess nach Anspruch 6, wobei der Prozess umfasst:
Bilden eines oder mehrerer weiterer flacher Gräben (150'), die einen Niederspannungsbereich (315) und einen Hochspannungsbereich (320) des Halbleiterkörpers (105) isolieren, und
Bilden einer oder mehrerer Niederspannungskomponenten (305) der integrierten Vorrichtung (300), die darauf ausgelegt sind, bei einer niedrigen Spannung zu arbeiten, im Niederspannungsbereich (315), wobei die Niederspannungskomponenten (305) eine oder mehrere aktive Regionen umfassen, die sich im Niederspannungsbereich (315) von der Hauptfläche (110) erstrecken, und
Bilden einer oder mehrerer Hochspannungskomponenten (310) der integrierten Vorrichtung (300), die darauf ausgelegt sind, bei einer hohen Spannung zu arbeiten, die höher ist als die niedrige Spannung im Niederspannungsbereich (320), wobei die Hochspannungskomponenten (310) eine oder mehrere aktive Regionen (325) umfassen, die sich im Hochspannungsbereich (320) von der flachen Fläche (155) mindestens eines ausgewählten der weiteren flachen Gräben (150) erstrecken.

8. Prozess nach Anspruch 7, wobei der Prozess umfasst:
Öffnen eines Komponentenfensters (340) über dem ausgewählten weiteren flachen Graben (150'), das mindestens einen Teil der flachen Fläche (155) desselben freilegt, zusammen mit dem Grabenfenster (165), und
Bilden der aktiven Regionen (325) der Hochspannungskomponenten (310) über dem Komponentenfenster (335).

9. Prozess nach Anspruch 8, wobei der Prozess umfasst:
Öffnen des Komponentenfensters (340) und des Grabenfensters (165) durch isotropes Ätzen.

## Revendications

1. Dispositif intégré (100 ; 300) étant intégré sur un corps semi-conducteur (105) ayant une surface principale (110), dans lequel le dispositif intégré (100 ; 300) comprend un bouchon profond (115) comprenant :
une tranchée profonde (120) s'étendant dans le corps semi-conducteur (105) jusqu'à une grande profondeur (Dd) depuis la surface principale (110), la tranchée profonde (120) ayant une surface latérale revêtue d'un revêtement isolant (130) en matériau électriquement isolant et la tranchée profonde revêtue (120) étant remplie d'un élément de remplissage conducteur (135) en matériau électriquement conducteur,
un contact de tranchée (140) en matériau électriquement conducteur qui est en contact avec l'élément de remplissage conducteur (135), et
une tranchée peu profonde (150) s'étendant dans le corps semi-conducteur (105) depuis la surface principale (110), la tranchée peu profonde (150) ayant une surface peu profonde (155) à une faible profondeur (Ds) depuis la surface principale (110), inférieure à la grande profondeur (Dd) et étant remplie d'un élément de remplissage isolant (160) en matériau électriquement isolant, dans lequel la tranchée profonde (120) s'étend depuis la surface peu profonde (155) jusqu'à la grande profondeur (Dd) et le contact de tranchée (140) est en contact avec l'élément de remplissage conducteur (135) à travers la tranchée peu profonde (150) au niveau de la surface peu profonde (155), dans lequel :
la tranchée peu profonde (150) est coaxiale avec la tranchée profonde (120),
une section transversale de la tranchée peu profonde (150) est plus grande qu'une section transversale de la tranchée profonde (120), et
une fenêtre de tranchée (165) traversant l'élément de remplissage isolant (160) expose une partie centrale de l'élément de remplissage conducteur (135), le contact de tranchée (140) étant en contact avec la partie centrale de l'élément de remplissage conducteur (135) à travers la fenêtre de tranchée (165),
**caractérisé en ce qu'**une paroi latérale de la fenêtre de tranchée (165) forme un angle de 20 à 70° avec la surface principale (110).

2. Dispositif intégré (300) selon la revendication 1, dans lequel le dispositif intégré (300) comprend une ou plusieurs autres tranchées peu profondes (150') qui isolent une zone à basse tension (315) et une zone à haute tension (320) du corps semi-conducteur (105), la zone à basse tension (315) comprenant un ou plusieurs composants à basse tension (305) du dispositif intégré (300) conçus pour fonctionner à une basse tension et la zone à haute tension (320) comprenant un ou plusieurs composants à haute tension (310) du dispositif intégré (300) conçus pour fonctionner à une haute tension supérieure à la basse tension, dans lequel les composants à basse tension (305) comprennent une ou plusieurs régions actives qui s'étendent dans la zone à basse tension (315) depuis la surface principale (110) et les composants à haute tension (310) comprennent une ou plusieurs régions actives (325) qui s'étendent dans la zone à haute tension (320) depuis la surface peu profonde (155) d'au moins une tranchée choisie parmi les autres tranchées peu profondes (150').

3. Dispositif intégré (300) selon la revendication 2, dans lequel une fenêtre de composant (340) traversant l'autre tranchée peu profonde choisie (150') expose au moins une partie de la surface peu profonde (155) de celle-ci, un ou plusieurs contacts de composant (335) étant en contact avec au moins une partie des régions actives (325) des composants à haute tension (310) à travers la fenêtre de composant (340).

4. Dispositif intégré (300) selon la revendication 3, dans lequel une paroi latérale de la fenêtre de composant (340) forme un angle de 20 à 70° avec la surface principale (110).

5. Système (500) comprenant au moins un dispositif intégré (300) selon l'une quelconque des revendications 1 à 4.

6. Procédé de fabrication d'un dispositif intégré (100 ; 300) intégré sur un corps semi-conducteur (105) ayant une surface principale (110), dans lequel le procédé comprend la formation d'un bouchon profond (115) comprenant les étapes suivantes :
former une tranchée profonde (120) s'étendant dans le corps semi-conducteur (105) jusqu'à une grande profondeur (Dd) depuis la surface principale (110),
revêtir une surface latérale de la tranchée profonde (120) d'un revêtement isolant en matériau électriquement isolant (130),
remplir la tranchée profonde revêtue (120) avec un élément de remplissage conducteur (135) en matériau électriquement conducteur,
former une tranchée peu profonde (150) s'étendant dans le corps semi-conducteur (105) depuis la surface principale (110) jusqu'à une surface peu profonde (155) à une faible profondeur (Ds) inférieure à la grande profondeur (Dd) pour que la tranchée profonde (120) s'étende de la surface peu profonde (155) à la grande profondeur (Dd),
remplir la tranchée peu profonde (150) d'un élément de remplissage isolant (160) en matériau électriquement isolant, et
former un contact de tranchée (140) qui est en contact avec l'élément de remplissage conducteur (135) au niveau de la surface peu profonde (155) à travers la tranchée peu profonde (150),
dans lequel la formation de la tranchée peu profonde (150) est réalisée après la formation de la tranchée profonde (120), le revêtement de la surface latérale de la tranchée profonde (120) et le remplissage de la tranchée profonde revêtue (120),
et dans lequel la formation du bouchon profond (115) comprend en outre les opérations suivantes :
ouvrir une fenêtre de tranchée (165) traversant la tranchée peu profonde (150) exposant au moins une partie de l'élément de remplissage conducteur (135), et
former le contact de tranchée (140) à travers la fenêtre de tranchée (165),
**caractérisé en ce qu'**une paroi latérale de la fenêtre de tranchée (165) forme un angle de 20 à 70° avec la surface principale (110).

7. Procédé selon la revendication 6, dans lequel le procédé comprend les étapes suivantes :
former une ou plusieurs autres tranchées peu profondes (150') qui isolent une zone à basse tension (315) et une zone à haute tension (320) du corps semi-conducteur (105), et
former un ou plusieurs composants à basse tension (305) du dispositif intégré (300) conçus pour fonctionner à une basse tension dans la zone à basse tension (315), les composants à basse tension (305) comprenant une ou plusieurs régions actives qui s'étendent dans la zone à basse tension (315) depuis la surface principale (110), et
former un ou plusieurs composants à haute tension (310) du dispositif intégré (300) conçus pour fonctionner à une haute tension supérieure à la basse tension dans la zone à haute tension (320), les composants à haute tension (310) comprenant une ou plusieurs régions actives (325) qui s'étendent dans la zone à haute tension (320) depuis la surface peu profonde (155) d'au moins une tranchée choisie parmi les autres tranchées peu profondes (150).

8. Procédé selon la revendication 7, dans lequel le procédé comprend les étapes suivantes :
ouvrir une fenêtre de composant (340) traversant l'autre tranchée peu profonde choisie (150') exposant au moins une partie de la surface peu profonde (155) de celle-ci en même temps que la fenêtre de tranchée (165), et
former les régions actives (325) des composants à haute tension (310) à travers la fenêtre de composant (335).

9. Procédé selon la revendication 8, dans lequel le procédé comprend l'étape consistant à ouvrir la fenêtre de composant (340) et la fenêtre de tranchée (165) par gravure isotrope.
